Europäisches Patentamt

European Patent Office

Office européen des brevets

(11) Numéro de publication: **0 258 363 B1**

(12) **FASCICULE DE BREVET EUROPEEN**

(45) Date de publication de fascicule du brevet: **17.06.92**   (51) Int. Cl.⁵: **H03K 17/969**

(21) Numéro de dépôt: **87901503.0**

(22) Date de dépôt: **24.02.87**

(86) Numéro de dépôt internationale :
**PCT/FR87/00045**

(87) Numéro de publication internationale :
**WO 87/05172 (27.08.87 87/19)**

(54) **PERFECTIONNEMENTS DES CLAVIERS OPTIOUES A BALAYAGE.**

(30) Priorité: **24.02.86 FR 8602479**
**02.10.86 FR 8613727**

(43) Date de publication de la demande:
**09.03.88 Bulletin  88/10**

(45) Mention de la délivrance du brevet:
**17.06.92 Bulletin  92/25**

(84) Etats contractants désignés:
**AT BE CH DE FR GB IT LI LU NL SE**

(56) Documents cités:
**DE-A- 2 012 091**
**DE-A- 2 618 143**
**US-A- 3 787 837**
**US-A- 4 417 824**

**G.E.C. JOURNAL OF RESEARCH, vol. 2, no. 2, 1984 (Londres, GB); P.R. WALLACE et al., "Engineering optical fibre sensors for process control", pages 129-134.**

**IBM TECHNICAL DISCLOSURE BULLETIN, vol. 22, no. 12, mai 1980, (New York, US); S.C. TSENG: "Opto-magnetic input tablet or keyboard", pages 5477-5478**

(73) Titulaire: **SOULOUMIAC, Alain**
**29, rue du Général Brunet**
**F-75019 Paris(FR)**

(72) Inventeur: **MARLAND, André**
**35, avenue Chevreul**
**F-92270 Bois-Colombes(FR)**
Inventeur: **FARGETTE, Alain**
**3, rue Nungesser**
**F-93150 Le Blanc-Mesnil(FR)**

(74) Mandataire: **Viard, Jean**
**Cabinet VIARD 28 bis, avenue Mozart**
**F-75016 Paris(FR)**

## Description

La présente invention concerne plus particulièrement les claviers optiques à balayage, c'est à dire les claviers dont le nombre des composants optiques permet de gérer une quantité de touches supérieure à celle qu'autoriserait l'emploi de touches équipées d'éléments de détection et de connexion individuels.

Du fait de la prolifération des microprocesseurs, les claviers à balayage sont devenus usuels sur des appareils tels les calculatrices, les machines à écrire, les systèmes de traitement de texte, les ordinateurs, les synthétiseurs musicaux, les distributeurs automatiques, etc. Plutôt que d'utiliser des touches à détection individuelle, c'est à dire des touches disposant chacune de connexions particulières avec le système qui les utilise, les touches sont connectées selon une matrice logique à un interface de balayage, qui informe le système auquel le clavier est connecté du résultat de ses scrutations concernant l'état des touches.

Par exemple, une calculatrice peut avoir 16 touches répartie en une matrice de 4 entrées (ou rangées) et 4 sorties (ou colonnes). Son clavier aura un interface balayant périodiquement les touches en envoyant un signal d'interrogation sur une première entrée et en scrutant le résultat sur les 4 sorties, etc. Ainsi le balayage d'une matrice de NxM touches offre l'avantage de réduire le nombre des entrées et des sorties requises par le clavier lui-même à M+N, au lieu des MxN autrement nécessaires. Dés que l'interface a déterminé qu'une ou plusieurs touches étaient enfoncées, il transmet cette information sous la forme d'un code adéquat vers le système utilisateur. Il peut être connecté de diverses manières au système utilisateur. Si des signaux série sont utilisés, alors deux ou trois lignes suffisent à n'importe quel nombre de touches. Si c'est une liaison parallèle, alors 4 lignes suffiront à un clavier comportant jusqu'à 16 touches, et 8 lignes permettront d'identifier jusqu'à 256 touches.

Chaque touche est liée à une intersection individuelle de la matrice. Elle opère selon une solution préférentielle en produisant deux états stables: un état dans lequel les entrées et sorties correspondantes sont couplées et un second état dans lequel elles ne sont pas couplées. Dans un clavier optique, les signaux utilisés sont des radiations visibles ou non visibles (rayons infrarouges ou ultraviolets par exemple). Ces signaux sont envoyés par les entrées, et les sorties du clavier sont scrutées pour déterminer si un couplage ou un non couplage s'est produit avec les signaux d'entrée. L'état de couplage est assuré à chaque intersection de la matrice par un élément qui est actionné par la touche correspondante. Cet élément est un obturateur ou un miroir mobile. Dans un clavier électrique, le couplage entre des matériaux conducteurs de courant est assuré par des interrupteurs marche/arrêt, bien que d'autres composants tels les interrupteurs capacitifs ou à effet Reed soient également utilisés.

D'autres méthodes peuvent être utilisées telles des variations de signal comme dans la réalisation du Journal of Research citée plus bas.

A priori, les claviers optiques offrent plusieurs avantages par rapport aux claviers électriques. Par exemple ils sont exempts de toute interférence électrique (en tant qu'émetteur mais aussi comme récepteur). Ils offrent par nature une sécurité supérieure (pas d'étincelles dans des atmosphères explosives), les rebonds sont réduits à la source, la durée de vie des composants est accrue (pas d'usure des contacts), etc.

Le problème majeur avec les claviers matriciels réside dans le résultat souvent aléatoire de l'enfoncement simultané de deux ou plusieurs touches. Ce problème se produit souvent lors de frappes rapides : un opérateur peut taper à des vitesses supérieures à 10 caractères par seconde. De ce fait, plusieurs touches peuvent se trouver enfoncées simultanément. C'est le problème communément appelé "Key rollover" : il importe que le système utilisateur puisse identifier les touches de manière fiable et dans l'ordre où elles ont été enfoncées. D'ailleurs, même sans frappe rapide, beaucoup de claviers imposent d'enfoncer plusieurs touches ensemble, comme la touche majuscule avec une autre, pour avoir accès à des signes ou à des fonctions déterminées. Ce problème est donc très général. Un autre problème, lié au premier, est celui des touches "fantômes" : l'enfoncement d'une touche non sollicitée par l'opérateur est simulé par la combinaison d'autres touches, et le système utilisateur ne dispose d'aucun moyen pour connaitre la réalité.

Dans un clavier optique, le problème d'une identification fiable de n'importe laquelle des touches même en présence de plusieurs touches enfoncées simultanément est résolu si l'on parvient à garantir d'une part l'accès à la lumière de toutes les touches quel que soit l'état des autres touches (couplage ou non couplage), et d'autre part que chaque photodétecteur pourra "voir" toutes les touches qui lui sont associées, quel que soit l'état des autres touches. Ceci revient à dire qu'un trajet optique entre chaque source de lumière et chacune des touches qui lui sont associées ne doit jamais être totalement obturé, et le trajet optique séparant chaque photodétecteur de chacune des touches qui lui sont associées ne doit jamais non plus être totalement obturé. Cette condition fondamentale est appelée ici "la condition de liberté des trajets optiques", étant entendu qu'une liberté partielle peut être tolérée dès lors qu'elle autorise un passage suffisant de lumière vers le photodétecteur le moins bien placé.

Un exemple de clavier optique est décrit dans le brevet US 3,056.030 (Kelcher). Ce document concerne une machine à écrire équipée d'un clavier optique. L'action de chaque touche coupe la lumière simultanément sur une rangée et sur une colonne. Ceci donne un système dans lequel toute touche située en aval d'une touche enfoncée se trouve privée de lumière, dans sa rangée ou dans sa colonne, selon les cas. Toutefois, tant qu'aucune touche n'est privée de lumière à la fois dans une rangée et dans une colonne, le clavier peut fonctionner correctement. Le système double le nombre des entrées et des sorties nécessaires = 2-(M + N). Ce brevet place les touches combinantes (majuscule, ou blocage majuscule par exemple qui sont nécessairement enfoncées simultanément ou en association avec d'autres touches), dans le voisinage immédiat des photodétecteurs qui leur sont associés, limitant ainsi le nombre de touches qu'elles peuvent masquer et permettant également qu'elles soient enfoncées simultanément avec au moins une autre touche quelconque. Cependant, sur le plan ergonomique, cette solution peut aboutir à créer des contraintes difficilement acceptables pour l'utilisateur.

Un premier clavier à satisfaire à la condition de liberté des trajets optiques est celui des figures 7 et 8 du brevet USA 3,856.127 (Halfon), dans lequel chacun de ces trajets optiques libres est individuellement constitué par une fibre optique. Ces fibres sont rassemblées en des rangées et des colonnes de faisceaux et chaque faisceau coopère avec la source de lumière ou le photodétecteur qui lui est associé. La construction d'un clavier bureautique de ce type soulève des difficultés sérieuses: cent interrupteurs d'un type nouveau restent à créer; quatre cent connexions doivent être réalisées; près de deux cent morceaux de conduits sont à positionner dans le boitier du clavier.

Un autre clavier à satisfaire à cette condition est celui représenté par le brevet USA 4,311.990 (Burke). Chaque source de lumière opère sur un arc relativement large (100° environ) et chaque photodétecteur reçoit la lumière sous un angle similaire. Un treillis de sources de lumière, de photodétecteurs et des obturateurs actionnés par les touches sont montés dans un boitier étanche à la lumière. Selon l'arrangement retenu, les sources de lumière et les photodétecteurs bien placés coopèrent avec quatre touches et les moins bien placés travaillent avec une ou deux touches seulement. Malgré le partage des sources de lumière et des photodétecteurs que cet arrangement autorise, il limite de fait le nombre maximum de touches qu'une source de lumière ou qu'un photodétecteur peut couvrir à 4. En conséquence, un clavier ayant une matrice logique de MxN touches aura besoin d'au moins MxN/4 sources de lumière et d'au moins MxN/4 photodétecteurs, soit au total plus de MxN/2 entrées et sorties, et en arrive à contredire ce faisant l'avantage normalement attendu d'un balayage des touches par rapport à une connexion individuelle de chacune d'entre elles.

Un autre inconvénient inhérent à ce type de structure tient à la manière dont sont disposés les sources de lumière et les photodétecteurs sur l'ensemble du clavier aux croisements appropriés du treillis. En pratique ceci implique un circuit imprimé et donc de l'électricité dans le clavier, ce qui conduit à se priver d'un des avantages majeurs des claviers optiques qui est l'absence d'interférences électriques.

Un troisième clavier optique est celui représenté à cette condition de liberté des trajets optiques est celui représenté par le brevet US -A- 4,417,824. Mais sa construction paraît complexe et son épaisseur importante ne semble pas en accord avec les normes ergonomiques dominantes aujourd'hui.

L'article intitulé ENGINEERING OPTICAL FIBRE SENSORS... publié dans 645 G.E.C Journal of Research 1984 n° 2 London Greet Britain, (WALLACE et al) décrit un clavier optique à fibres utilisant la perte de transmission par cintrage de deux fibres optiques perpendiculaires l'une à l'autre sous la pression d'une touche, l'ensemble des entrées et sorties est disposé sur un côté du bloc optique mais ce clavier est constitué par une matrice sans balayage, d'où notamment un grand nombre d'entrées et de sorties qu'il est difficile de gérer.

US -A- 3 787 837, se rapporte à un clavier optique dans lequel chaque touche permet de connecter ou de déconnecter un conduit d'entrée et un conduit de sortie.

L'objet de la présente invention est un clavier optique à balayage comportant un bloc optique plat dont la face supérieure est destiné à coopérer avec des touches, des entrées de lumière et des sorties de lumière dont les intersections couplent une entrée et une sortie de lumière, des éléments couplant une entrée ou découplant les entrées et les sorties situés aux intersections actionnées par les touches des conduits optiques libres depuis l'entrée de lumière jusqu'à leur intersection matricielle correspondante et depuis celle-ci jusqu'à leur sortie de lumière correspondante, et un étage de balayage envoyant un signal successivement sur chacune des entrées et scrutant après l'émission de chaque signal l'état de chacune des sorties, les entrées de lumière et les sorties de détection étant disposées sur un des mêmes bords du dit bloc optique, chaque emplacement de touche étant relié directement à un seul émetteur et à un seul récepteur de lumière par deux conduits optiques caractérisé en ce que les conduits optiques s'étendent parallèlement sur la face du bloc optique portant les éléments de couplage les croisements physiques établissant la matrice logique étant réalisés sur l'autre face du bloc optique sur des conduits qui ne comporte qu'un type de conduits d'entrée ou de sortie.

La construction du clavier est grandement simplifiée lorsque les conduits optiques partent et arrivent sur le même bord du bloc optique : - Si les composants optoélectroniques sont placés sur le bloc optique, il devient inutile de créer une baguette de connectique électrique distincte pour chacun d'eux. De plus quand on construit ces claviers en utilisant une seule fibre ou quelques conduits optiques seulement que l'on coupera postérieurement, cette disposition apparaît favorable à l'homogénéité des conduits, à la réalisation de circuits courts et donc à l'économie générale du clavier. D'ordinaire, le côté le plus éloigné de l'utilisateur fournit sur les claviers un espace propice au passage de ces fibres. - Si ces composants sont reliés à l'électronique par des liaisons optiques, il n'est pas nécessaire de prévoir des courbures étroites qui risquent d'affecter leur solidité et leur fiabilité, pour joindre des conduits optiques situés sur des côtés différents. Pour ces raisons, il apparaît préférable de placer l'ensemble des composants ou des liaisons optiques sur un même côté.

Le clavier selon la présente invention conserve un fonctionnement logique matriciel alors qu'il n'est plus constitué par une matrice. Le fait de disposer de conduits parallèles sur une face permet une grande liberté dans l'implantation des touches.

La présente invention concerne également un procédé de fabrication d'un clavier optique caractérisé en qu'il consiste à:

prévoir des guides de groupage pour grouper les conduits d'entrée et les conduits de sortie de détection;

prévoir des guides de passage des conduits auprès des points de couplage et de découplage actionnés par les touches;

prévoir une certaine quantité de conduits optiques qui puisse suivre le premier guide de groupage des conduits d'entrée ou de sortie, puis autour des guides de passage des points de couplage, puis suivre un second guide de groupage de sortie ou d'entrée correspondant au premier guide de groupage et au point de couplage traversé;

prévoir une répétition de ces actions de filage en ramenant les conduits vers le bloc optique de sorte à couvrir tous les points de couplage de touches;

installer les moyens destinés à être opérés par les touches pour coupler ou découpler les conduits d'entrées avec les conduits de sorties.

D'une manière générale il est utile que les conduits puissent être percés ou sectionnés sur le mécanisme obturateur ou réflecteur. Dans la plupart des cas, cette précaution facilite la construction du clavier et garantit le bon positionnement des conduits.

Selon une variante de ce procéde de fabrication des gorges pinçantes sont prévues pour positionner les conduits sur les moyens de couplage. Selon une autre variante, des encoches de sertissage peuvent développer le rôle des guides de groupage en préparant le compactage, la coupure et la connexion de chaque faisceau de conduits d'entrée ou de sortie. Selon une disposition préférentielle, ces guides de groupage, ou encoches de sertissage, ou les deux s'ils sont présents, doivent tendre à permettre de couvrir tous les moyens de couplage de touches avec des conduits d'un seul tenant.

Le présent brevet se propose en outre de développer les performances de ce clavier en faisant en sorte que le bloc optique réponde à une triple exigence: indépendance de l'électronique, indépendance de l'environnement et indépendance des touches.

Indépendance de l'électronique. - La présente invention tend à rendre la partie optique indépendante de l'électronique du clavier, qui peut être rapatriée à bord du système auquel il est connecté. Des liaisons optiques avec le système électronique auquel le bloc est connecté permettent en effet de réduire ou de supprimer la partie électrique et électronique du clavier. Ceci présente l'avantage de faire disparaitre toute sensibilité du clavier aux rayonnements nucléaires, à l'électricité statique, aux ondes de choc. Ceci supprime également tous les risques d'étincelles ou d'émission d'ondes radioélectriques.

Indépendance de l'environnement.- L'indépendance par rapport à l'électronique permet d'affranchir fortement le fonctionnement du bloc de ses conditions d'environnement. S'agissant d'optique, il convient de protéger tout particulièrement les parties sensibles du bloc des risques de lumière, de poussière et d'oxydation. L'étanchéité minimum du bloc peut être garantie par le fait que les mécanismes de contact ou de réflexion sont enfermés dans un ensemble étanche grâce à une membrane élastique ou à des moyens magnétiques permettant de transmettre les mouvements d'interruption.

Indépendance de la mécanique des touches.- Le bloc optique est séparé de la partie supportant les touches du clavier. Puisque ce bloc optique est indépendant des touches, l'adoption de réglages ergonomiques du clavier accessibles à l'utilisateur concernant en particulier la course des touches et leur sensibilité devient aisé. Ce bloc optique peut être conçu pour permettre une disposition en fonction de diverses topologies d'implantation des touches. Pour cette raison, les interrupteurs optiques peuvent être en surnombre et les trajets optiques disposés à un pas tel que chaque touche, quelque soit sa position dans la rangée ou colonne correspondante, puisse en intercepter au moins un.

Plusieurs modes de réalisation de ce clavier optique sont décrits, à titre d'exemple, en faisant référence aux dessins annexés parmi lesquels:

- les figures 1 & 2 représentent deux vues d'un mode d'agencement de conduits sur le bloc optique, respectivement en perspective et vue de dessus du passage des conduits;
- la figure 3 représente un mode de réalisation d'un premier interrupteur de conduit;
- la figure 4 représente un mode de réalisation d'un second interrupteur;
- la figure 5 représente une vue d'un second mode d'agencement des conduits sur le bloc optique;
- la figure 6 représente une vue d'un autre mode d'agencement des conduits optiques réalisé grâce à un enrichissement des fonctions prises en charge par les conduits optiques.
- les figures 7 à 10 représentent divers modes de réalisation d'interrupteurs optiques.
- les figures 11 et 12 représentent deux modes de ramification des liaisons optiques;
- la figure 13 un mode de ramification déterminant un mode de disposition particulier des conduits optiques sur le support;
- la figure 14 un autre mode de passage particulier des conduits optiques sur le support optique.

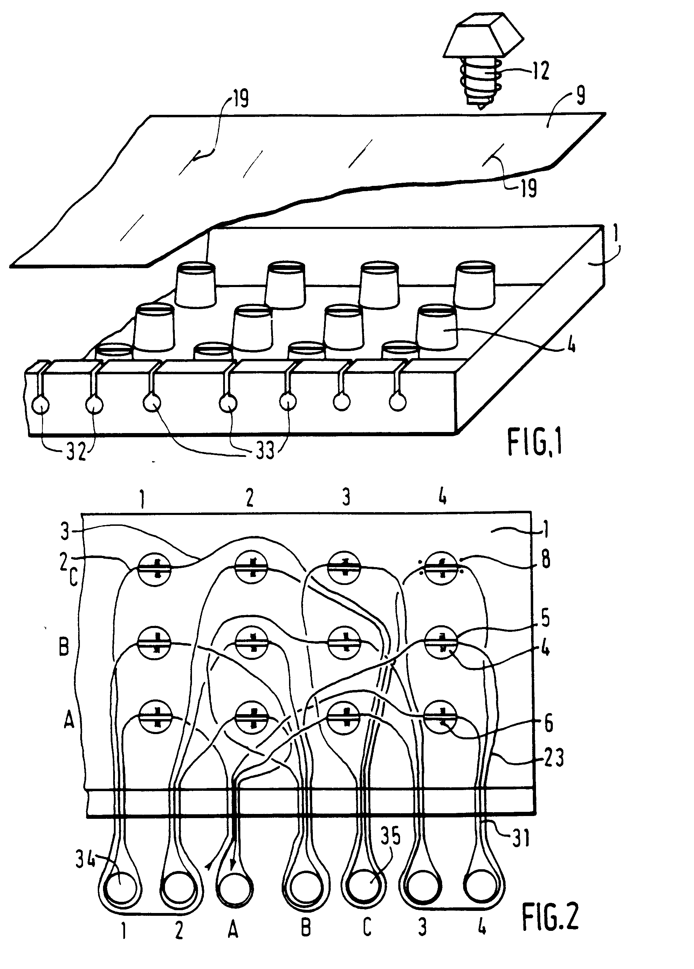

Sur les figures 1 et 2, le bloc optique est formé d'un support creux rectangulaire 1. Ce mode mode réalisation répond à la fois au principe de liberté des conduits qui conditionne la fiabilité et les performances du clavier, d'unité des conduits qui simplifie la fabrication et d'indépendance du bloc optique qui étend sa gamme d'utilisation.

Le bloc optique 1 est parcouru de couples de conduits, qui dans la réalisation présentée sont des fibres 2,3 (FIG.2) dont l'une amène la lumière, éventuellement concentrée par une lentille, et l'autre renvoie le signal. Ces deux fibres sont réunies par un interrupteur 4 commandé par une touche 12 (FIG.1). La plaque 9 fermant le boitier 1 est percée de fentes 19 guidant le passage des lames obturatrices.

La disposition des fibres suit un ordre d'implantation logique des interrupteurs (A1, A2, A3, B1, B2, B3, C1...). Elle peut être aisément réalisée en passant une seule fibre que l'on découpe ensuite. Cette fibre peut être positionnée soit autour d'interrupteurs 4 spécialement conçus pour ce faire, soit autour d'un patron de guides mobile. Extérieurs au clavier, des guides de groupage 34,35 (FIG.2) facilitent le passage des fibres tandis que des encoches de sertissage 32,33 (FIG.1) préparent les connexions avec les entrées et les sorties de lumière. Dans la mesure où le nombre de fibres n'est pas le même en un point donné, ces encoches 32, 33 ne sont pas nécessairement de dimensions égales.

Des guides de passage 8 (FIG.2) peuvent servir à l'installation des fibres au niveau des interrupteurs.

Une fois la fibre positionnée sur l'interrupteur, elle est enfoncée dans une gorge 5 pour y être fixée. Cette gorge peut comporter un passage étroit de sorte à ce que la fibre ne puisse resortir. Fixée définitivement, elle est sectionnée 6 et éventuellement polie pour recevoir l'obturateur.

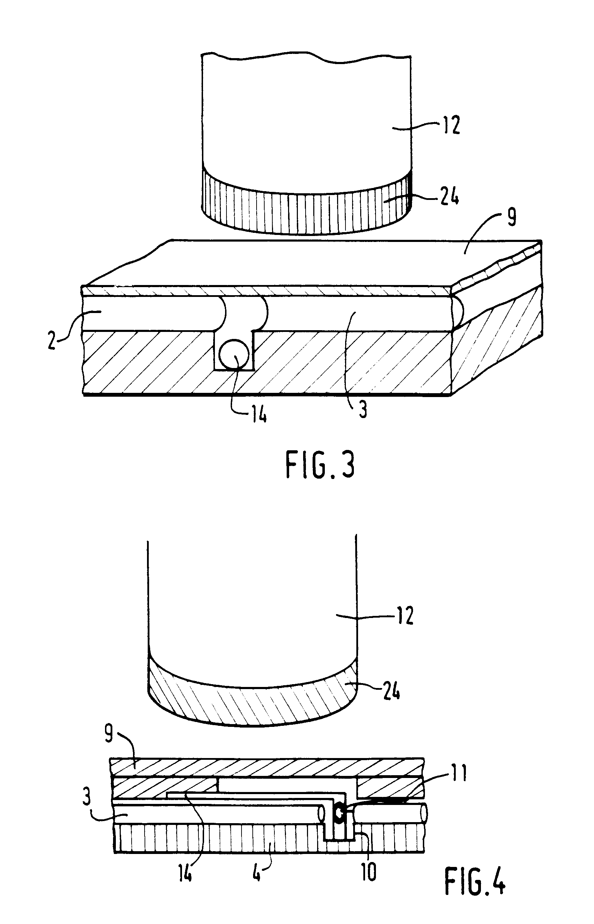

Ce sectionnement de la fibre peut être opéré dans la masse du coupleur. Une pré-saignée 10 (FIG.4) peut aussi être aménagée dans le coupleur pour faciliter ces opérations. Dans ce dernier cas, la présaignée peut descendre plus profondément que la gorge 5 prévue pour recevoir le conduit 3 et la coupe du conduit peut avoir pour effet d'élargir légèrement cette présaignée jusqu'au niveau le plus bas de la gorge 5. Cet épaulement 10 étant prévu pour que l'obturateur une fois en place ne puisse jamais frotter la fibre et détériorer ses qualités optiques.

Selon ce mode de fabrication la disposition du support optique destiné à recevoir la fibre est matériellement prédéterminée.

Selon une variante de ce mode de fabrication, une fibre est placée sur un interrupteur discret comportant une gorge 5. Ces interrupteurs sont travaillés selon le processus décrit précédemment pour recevoir leur obturateur. Cet interrupteur est ensuite placé à l'emplacement souhaité du clavier et les deux extrémités des fibres 2 et 3 sont chacune affectées à l'entrée et à la sortie de lumière qui leur sont propres.

Selon une autre variante de ce mode de fabrication, une série d'interrupteurs sont fixés sur le conduit à des distances convenables par leurs gorges 5. Ce chapelet d'interrupteurs est ensuite positionné sur le clavier selon le processus décrit par la figure 2.

La figure 3 représente un interrupteur étanche grâce au couvercle 9 qui recouvre son boitier. L'ensemble du support optique et, éventuellement, l'électronique peuvent être ensuite noyés dans un matériau solide pour parfaire l'étanchéité du clavier aux liquides et aux poussières. Lorsque le conduit 2,3 est en place, il est percé et le boitier 1 reçoit une bille 14, qui sous l'action d'un aimant 24 - placé par exemple à la base de la tige 12 - obturera le conduit optique 2. Si l'on utilise le bloc optique renversé, l'attraction magnétique libèrera au contraire la bille de la fibre. Autrement dit, les deux faces du bloc optique peuvent être utilisées pour combiner deux claviers différents sur un même bloc.

La figure 4 reprend les mêmes principes, mais la bille est remplacée par un ressort 4 revenant en position repos une fois que l'aimant a cessé de produire ses effets. Ce ressort rend le clavier moins sensible aux chocs et lui permet de travailler en état d'apesanteur. Un résultat similaire pourrait être obtenu sur le clavier à billes en installant sous le clavier un contre-aimant.

Cet obturateur peut selon les cas couper la lumière, ou inversement, la laisser circuler en position repos. Il peut notamment être percé pour ce faire 11 (FIG.4). Que la forme de l'obturateur soit celle d'un levier linéaire, ou hélicoïdal par exemple, qu'il ou la tige soit magnétique ou les deux, que l'aimantation se fasse verticalement ou latéralement importent peu. Ce qu'il faut souligner c'est que le magnétisme se marie particulièrement bien avec l'optique: nons seulement il permet une étanchéité parfaite mais il favorise également le rapprochement de la durée de vie mécanique et de la durée de vie optique du clavier en éliminant les sources de frottement et d'usure.

Les fibres étant peu épaisses et les interrupteurs optiques ne nécessitant pas de courses supérieures au mm, le bloc optique lui-même ne dépasse pas une épaisseur de quelques mm au plus. On dispose donc tant en épaisseur qu'en surface de suffisamment d'espace pour construire une matrice surdimensionnée, chaque configuration particulière n'utilisant qu'un sous-ensemble de ladite matrice. Ces claviers peuvent répondre à divers soucis tels faciliter la production par une plus grande souplesse, répondre à des fonctions de sécurité, ou encore permettre la réalisation de claviers double face.

La plupart de ses qualités se retrouvent dans les autres modes de réalisation qui suivent.

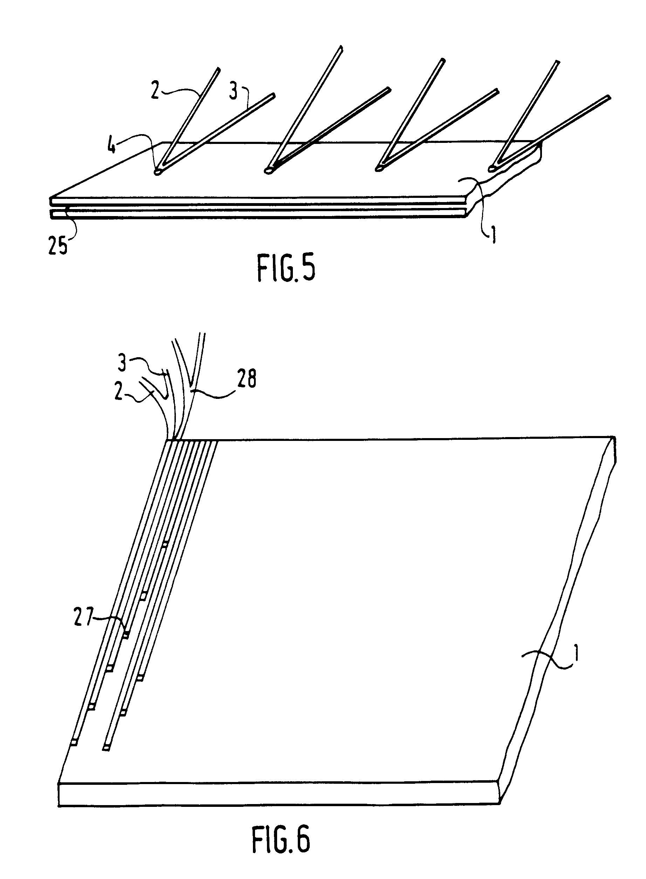

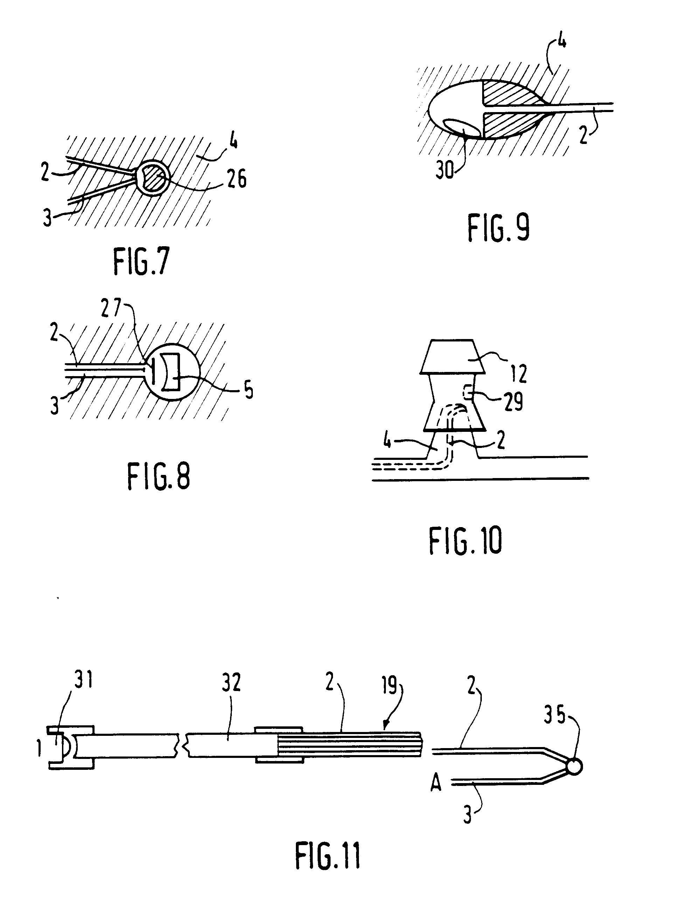

Selon un deuxième mode de réalisation (FIG.5), le bloc optique est formé d'une série de rangées 1 qui s'emboitent grâce à un rail latéral 25, ou tout autre dispositif assurant une fonction similaire, et qui comportent chacune une série d'emplacement de touches. A chacun de ces emplacements se trouve un réflecteur mobile (26 FIG.7), ou un réflecteur fixe précédé d'un obturateur (27 FIG.8).

Cette deuxième façon de réaliser les claviers peut se combiner avantageusement avec d'autres types d'interrupteurs si, par exemple, on place les conduits d'entrée 2 et de sortie 3 côte à côte. L'attraction magnétique ou l'action mécanique d'une touche modifie le couple établit par le réflecteur 26 qui renvoit la lumière venant du conduit 2 dans le conduit 3. Pour le reste, ce bloc fonctionne selon des principes similaires aux réalisations déjà décrites.

Selon un troisième mode de réalisation (FIG.6), les conduits 2 et 3 sont connectés par un coupleur collecteur en Y à un troisième conduit 28. C'est ce troisième conduit qui parcourt le bloc optique, apporte la lumière et ramène le signal grâce à l'action d'un réflecteur obturable 27 placé à son extrémité. Ce clavier facilite une souplesse d'implantation des touches, chaque fibre s'intégrant à la touche dont l'emplacement devient libre dans la limite de longueur du conduit disponible.

A l'extrémité des conduits 2, constitués de fibres optiques par exemple, se trouve fixé un réflecteur obturable magnétiquement du type de ceux représentés par les figures 6 à 10. Lorsque la touche est approchée, l'obturateur du réflecteur ou le réflecteur lui-même est attiré magnétiquement. Il bloque alors le renvoi du signal lumineux dans la fibre. Inversement il est possible que l'enfoncement d'une touche libère le réflecteur.

Des variantes sont possibles, la touche 12 peut par exemple être elle-même équipée d'un réflecteur 5 et son enfoncement aboutir au même résultat (FIG.10).

D'une manière générale, quelle que soit la réalisation considérée, il peut apparaître souhaitable que l'électronique devienne totalement indépendante du bloc optique. L'usage de fibres optiques amenant la lumière de l'électronique et la ramenant vers elle permet de réaliser cette indépendance. Ces fibres sont connectées sur un même bord du bloc optique en lieu et place des émetteurs et détecteurs. Ce bord généralement situé à l'arrière du clavier fournit la surface nécessaire aux flexions de fibres que rend nécessaire leur regroupement. C'est ainsi que l'électronique pourra être installée dans l'unité de traitement.

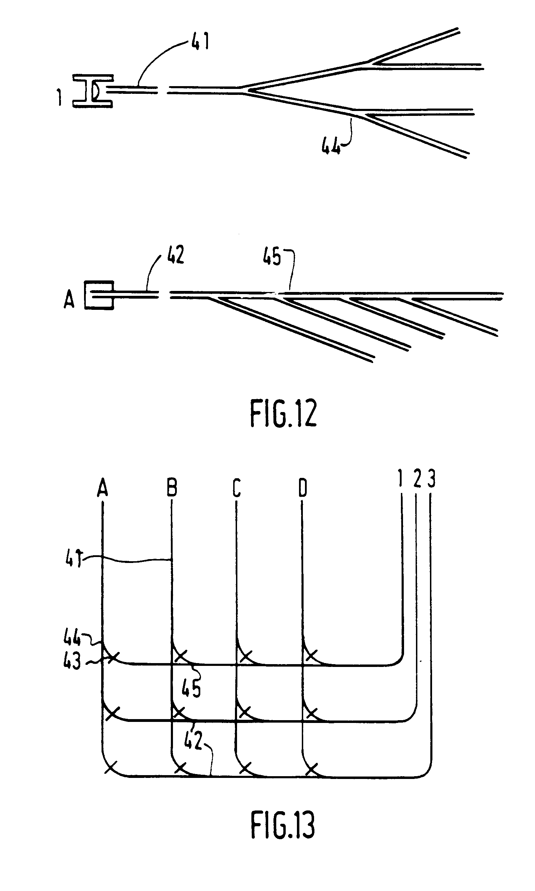

Un schéma de connexions optiques est donné par la figure 11. La lumière est amenée d'une diode 31 vers le clavier grâce à une fibre émettrice principale 32. Sur le bloc optique cette fibre 32 est connectée aux fibres émettrices secondaires qui vont chacune être ensuite amenée vers leur coupleur particulier 33. Les signaux retournent ensuite vers le photodétecteur de l'unité électronique par une fibre réceptrice secondaire 3, qui rejoint une fibre collectrice principale selon un processus similaire. Cette dernière fournit l' information correspondante à l'état de la touche à l'unité de traitement électronique.

Des liaisons plus élaborées peuvent aussi contribuer à la rationalisation de la construction des claviers, que l'électronique lui soit intégrée ou non (FIG.12). Des coupleurs optiques diviseurs 44 sont installés pour répartir la lumière jusqu'aux éléments coupleurs interrupteurs (non représentés). Selon un processus similaire, des coupleurs optiques collecteurs 45 servent à ramener la lumière vers le récepteur correspondant - les modes de réalisation de ces coupleurs optiques diviseurs et/ou collecteurs 44,45 étant connus, il n'apparaît pas utile de les décrire plus longuement ici.

Une autre disposition particulière de clavier optique (FIG.13) peut être réalisée à partir de cette variante en installant un conduit optique émetteur par colonne 41, un conduit collecteur par rangée 42 et en plaçant chaque coupleur interrupteur 43 entre le coupleur diviseur 44 et le coupleur collecteur 45 correspondant. Cette réalisation particulière est facilitée en intégrant la fabrication du coupleur diviseur 44 ou le coupleur collecteur 45, ou les deux, avec celle du coupleur interrupteur.

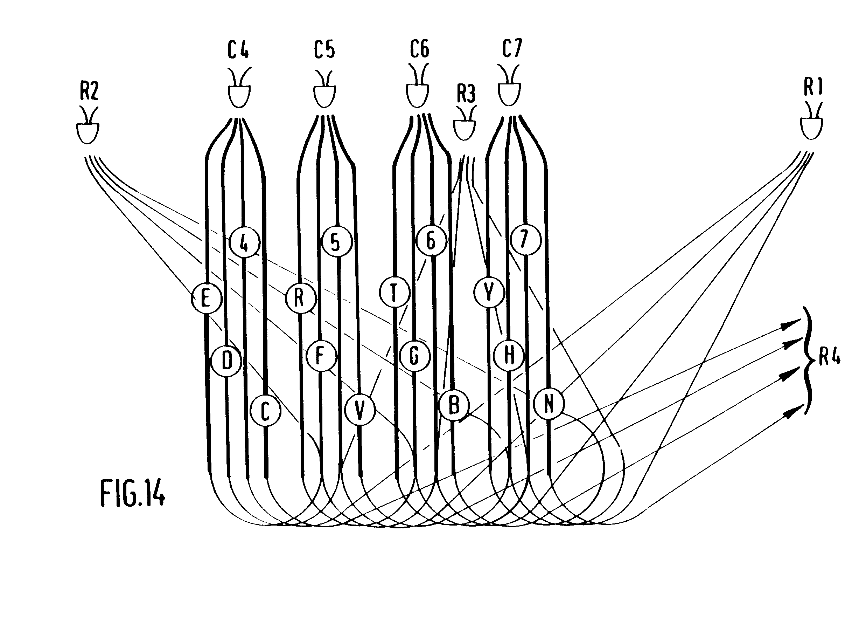

La figure 14 représente la vue partielle d'un clavier constitué par des conduits optiques, telles des fibres optiques. Chaque touche agit comme un obturateur qui établit sur une fibre déterminée une position de couplage, en laissant ou en ne laissant pas passer la lumière selon qu'elle est ou non enfoncée, ou l'inverse.

Dans cette réalisation, les fibres de colonne se répartissent en directions parallèles sur la surface plane d'un support de base (non représenté), et sont matérialisées sous la forme de traits gras. Les touches sont montées sur la surface supérieure du support de base. Des émetteurs (ou des récepteurs) de colonnes C4, C5, C6 et C7 sont représentés en face des colonnes de fibres. Au bas de la rangée inférieure de touches C, V, B, N, ..., les fibres virent selon un arc vers la droite en passant sous le support de base. Sous celui-ci, les fibres sont représentées en traits fins, et elles vont vers les récepteurs (ou émetteurs) de rangées R1, R2, R3 et R4. Les récepteurs peuvent être placés sous le support de base dans les intervalles des émetteurs de colonne. Dans l'hypothèse de 16 colonnes de 4 rangées, les récepteurs de rangées seraient disposés à un quart du pas séparant les émetteurs de colonnes.

Physiquement, la partie supérieure du support de base soutient une structure de fibres parallèles avec des touches placées sur une disposition ne comportant généralement aucun croisement, alors que sous la surface ou sur son extrémité inférieure s'opèrent les croisements nécessaires à l'organisation convenable du balayage, ce qui évite les contraintes pesant ordinairement sur le choix de l'emplacement des touches. Ce système évite aussi d'imposer aux fibres des virages trop serrés. Il peut également permettre de placer tous les émetteurs et les récepteurs sur un même coté du support. Dans cet exemple, comme dans ceux qui suivent moyennant certaines adaptations, les émetteurs peuvent remplacer les récepteurs et vice-versa. Ce clavier peut naturellement se combiner avec certaines des réalisations précédentes.

**Revendications**

1. Clavier optique à balayage comportant un bloc optique plat dont la face supérieure (9) est destiné à coopérer avec des touches (12), des entrées de lumière (2) et des sorties de lumière (3) dont les intersections (4) couplent une entrée et une sortie de lumière, des éléments couplant ou découplant les entrées et les sorties situés aux intersections actionnées par les touches (12), des conduits optiques libres depuis l'entrée de lumière jusqu'à leur intersection matricielle correspondante et depuis celle-ci jusqu'à leur sortie de lumière correspondante, et un étage de balayage envoyant un signal successivement sur chacune des entrées et scrutant après l'émission de chaque signal l'état de chacune des sorties, les entrées de lumière et les sorties de détection étant disposées sur un des mêmes bords (31) du dit bloc optique, chaque emplacement de touche étant relié directement à un seul émetteur et à un seul récepteur de lumière par deux conduits optiques (2, 3), caractérisé en ce que les conduits optiques s'étendent parallèlement sur la face du bloc optique partant les éléments de couplage (4), les croisements physiques établissant la matrice logique étant réalisés sur l'autre face du bloc optique qui ne comporte qu'un type de conduits d'entrée (2) ou de sortie (3).

2. Clavier optique selon la revendication 1 caractérisé en ce qu'il comporte une pluralité de couples de deux conduits côte à côte, l'un (2) d'entrée de lumière, l'autre (3) de sortie de détection, dont le couplage est commandé soit par un réflecteur mobile (26) soit par un obturateur associé avec le réflecteur (27).

3. Clavier optique selon la revendication 1 caractérisé en ce que les conduits d'entrée et de sortie (2, 3) correspondant à chaque point d'intersection sont liés en forme de Y et en ce que le pied du Y est constitué d'un conduit rejoignant le point où la touche exerce son couplage grâce à un réflecteur (27, 29, 30) destiné à renvoyer ou non la lumière dans un sens opposé selon la position de la touche.

4. Clavier optique selon l'une des revendications 1 à 3 caractérisé en ce qu'il ne contient aucune partie électrique et en ce que les liaisons avec le centre électronique sont assurées par des moyens optiques (32).

5. Clavier selon l'une des revendications 1 à 4 caractérisé en ce que les coupleurs interrupteurs (14, 26, 27, 30) sont isolés de l'environnement grâce à des commandes magnétiques.

6. Clavier selon l'une des revendications 1 à 5 caractérisé en ce que les coupleurs interrupteurs (14, 26, 27, 30) sont reliés à des coupleurs collecteurs (45) et/ou à des coupleurs diviseurs (44).

7. Un procédé de fabrication d'un clavier optique selon la revendication 1 consistant à placer un seul conduit sur chaque coupleur interrupteur et à ensuite sectionner chacun desdits conduits au niveau desdits coupleurs, créant ainsi deux conduits (2, 3) aptes à relier ledit coupleur interrupteur à l'une des entrées et l'une des sorties optiques.

8. Un procédé de fabrication d'un clavier optique selon la revendication 7 caractérisé en ce qu'il consiste :
   - à prévoir des guides de groupage (34, 35) pour regrouper les conduits d'entrée (2) et les conduits de sortie (3) en vue de les connecter à leurs sources de lumière et à leurs détecteurs respectifs ;
   - à ménager des guides de retenue (8 et/ou 5) pour les conduits auprès des points de couplage actionnés par les touches ;
   - à passer les conduits optiques autour d'un guide de groupage des conduits d'entrée (34) ou de sortie (35), puis autour du guides de retenue (8 et/ou 5) du point de couplage correspondant, pour revenir vers un second guide de groupage de sortie (35) ou d'entrée (34) correspondant au premier guide groupage et au point de couplage traversé ;
   - à répéter ces actions de passage en ramenant le conduit dans le bloc optique de sorte à couvrir tous les points de couplage de touches ;
   - à couper les conduits d'entrée et de sortie au niveau des guides de groupage de sortie (34) et d'entrée (35).

9. Un procédé de fabrication d'un clavier optique selon la revendication 7 caractérisé en ce qu'il consiste :
   - à installer les conduits optiques sur les coupleurs (4) ;
   - à prévoir des guides de groupage (34, 35) pour regrouper les conduits d'entrée (2) et les conduits de sortie (3) en vue de les connecter à leurs sources de lumière et à leurs détecteurs respectifs ;
   - à passer des conduits optiques autour d'un guide de groupage des conduits d'entrée (34) ou de sortie (35), puis à positionner le coupleur (4), pour revenir vers un second guide de groupage de sortie (35) ou d'entrée (34) correspondant au premier guide de groupage et au point de couplage positionné ;
   - à répéter ces actions de passage en ramenant le conduit dans le bloc optique de sorte à placer tous les points de couplage de touches ;
   - à couper les conduits d'entrées et de sortie au niveau des guides de groupage de sortie (34) et d'entrée (35).

**Claims**

1. An optical keyboard comprising : a flat optical block whose top face (9) is intended to co-operate with keys (12); light inlets (2) and light detection outlets (3) having intersections (4) which couple one light inlet with one light detection outlet, key-actuated elements situated at the intersections for coupling or decoupling the inlets and the outlets; optical ducts which are unobstructed from a corresponding light inlet to a corresponding matrix intersection, and from a corresponding matrix intersection to a corresponding light detection outlet; and a scanning stage for applying a signal successively to each of the inlets and for observing the state of each of the outlets after each signal application; the light inlets and the light detection outlets being disposed along the same one of the sides (31) of said optical block, with each key emplacement being directly connected to a single light emitter and a single light receiver via respective optical ducts (2, 3), characterized in that the optical ducts extend parallel over one of the faces of the keyboard with the physical crossovers that establish the logical matrix being located over its opposite face comprising only one kind of inlet optical ducts (2) or outlet optical ducts (3).

2. An optical keyboard according to claim 1, characterized in that it includes pairs of side-by-side ducts, one (2) being a light inlet duct and the other (3) being a light outlet detection duct, with the ducts being coupled under the control of a moving reflector (26) or of a shutter associated with a reflector (27).

3. An optical keyboard according to claim 1, characterized in that the inlet and outlet ducts (2, 3) corresponding to each intersection point are connected in a Y-configuration, and in the the foot of the Y is constituted by a duct going to the point where a key exerts its coupling by means of a reflector (27, 29, 30) for returning or not returning light in the opposite direction depending on the key position.

4. An optical keyboard according to any one of claims 1 to 3, characterized in that it contains no electronic parts, and in that the connections with the electronic center are provided by optical means (32).

5. A keyboard according to any one of claims 1 to 4, characterized in that the on/off couplers (14, 26, 27, 30) are isolated from the environment by means of magnetic controls.

6. A keyboard according to any one of claims 1 to 5, characterized in that the on/off couplers (14, 26, 27, 30) are integrated with light-collecting couplers (45) and/or light-splitting couplers (44).

7. A method of manufacturing an optical keyboard according to claim 1, consisting in placing a single light duct on each on/off coupler and then in cutting each of said ducts at said couplers, thereby creating two ducts (2, 3) suitable for connecting each of said on/off couplers to one of the light inlets and to one of the light detection outlets.

8. A method of manufacturing an optical keyboard according to claim 7 , characterized in that it consists in:
    providing grouping guides (34, 35) for grouping together the inlet ducts (2) and the outlet ducts (3) for the purpose of connecting them to their respective light sources and light detectors;
    providing retaining guides (8 and/or 5) for retaining the ducts at the key-actuated coupling points;
    threading the optical ducts around a grouping guide for inlet ducts (34) or for outlet ducts (35), then around the retaining guides (8 and/or 5) of a corresponding coupling point, then returning to a second grouping guide for outlet ducts (35) or for inlet ducts (34) corresponding to the first grouping guide and to the coupling point passed through;
    repeating these threading actions by returning the duct into the optical block so as to equip all of the key coupling points; and
    cutting the inlet ducts and the outlet ducts at the inlet grouping guides (34) and at the outlet grouping guides (35).

9. A method of manufacturing an optical keyboard according to claims 1 and 7, characterized in that it consists in:
    in installing the optical ducts on the on/off couplers (4);
    providing grouping guides (34, 35) for grouping together the inlet ducts (2) and the outlet ducts (3) for the purpose of connecting them to their respective light sources and light detectors;
    threading the optical ducts around a grouping guide for inlet ducts (34) or for outlet ducts (35), then positioning the coupler (4), then returning to a second grouping guide for outlet ducts (35) or for inlet ducts (34) corresponding to the first grouping guide and to the positioned coupling point;
    repeating these threading actions by returning the duct into the optical block so as to equip all of the key coupling points; and
    cutting the inlet ducts and the outlet ducts at the inlet grouping guides (34) and at the outlet grouping guides (35).

**Patentansprüche**

1. Optische Abtast-Tastatur, bestehend aus einem flachen optischen Block, dessen oben liegende Seite (9) vorgesehen ist mit Tasten (12) Zusammenzuwirken, mit Lichteingängen (2) und Lichtausgängen (3), deren Schnittstellen je einen Lichteingang und -ausgang miteinander koppeln, mit Elementen zum Koppeln oder Entkoppeln der an den von den Tasten (12) betätigten Schnittstellen anliegenden Ein- und Ausgänge, und mit optischen Leitern, welche vom Lichteingang zu ihrer entsprechenden matrizenförmigen Schnittstelle und von dieser bis zu ihrem entsprechenden Lichtausgang freiliegend verlaufen, und bestehend aus einer Abtast-Stufe, welche nacheinander an jeden Eingang ein Signal sendet und nach dem Absenden jedes Signals den Zustand aller Ausgänge überprüft, wobei die Lichteingänge und die Erkennungsausgänge an einem derselben Ränder (31) des optischen Blocks angeordnet sind, und wobei jede Tastenstelle durch zwei optische Leiter (2, 3) direkt mit einer einzigen Lichtquelle und einem einzigen Lichtempfänger verbunden ist, dadurch gekennzeichnet, daß die optischen Leiter sich parallel auf der Seite des optischen Blocks erstrecken, welche die Koppelelemente (4) trägt, und daß die physischen Kreuzungen, welche die logische Matrix darstellen, auf der anderen Seite des Blocks, die nur eine Art von Eingangsleitern (2) oder Ausgangsleitern (3) umfaßt, ausgeführt sind.

2. Optische Tastatur nach Anspruch 1, dadurch gekennzeichnet, daß sie eine Anzahl von Seite an Seite angebrachten Leiter-Paaren enthält, wobei ein Leiter (2) vom Lichteingang, der andere (3) vom Erkennungsausgang kommt, und wobei die Kopplung entweder von einem beweglichen Reflektor (26) oder von einem mit dem Reflektor (27) verbundenen Verschluß gesteuert wird.

3. Optische Tastatur nach Anspruch 1, dadurch gekennzeichnet, daß die jeweiligen Eingangs- und Ausgangsleiter (2, 3) der einzelnen Schnittstellenpunkte in Form eines Y miteinander verbunden sind, und daß der Fuß des Y aus einem Leiter besteht, der zu dem Punkt führt, an welchem die Taste ihre Kopplung mit Hilfe eines Reflektors (27, 29, 30) ausführt, welcher dazu vorgesehen ist, das Licht je nach Position der Taste in die entgegengesetzte Richtung zurückzuschicken oder nicht.

4. Optische Tastatur nach einem der Ansprüche 1 bis 3, dadurch gekennzeichnet, daß sie über keinerlei elektrische Partien verfügt, und daß die Verbindungen mit dem elektronischen Zentrum durch optische Mittel (32) hergestellt werden.

5. Optische Tastatur nach einem der Ansprüche 1 bis 4, dadurch gekennzeichnet, daß die Unterbrechungskoppler (14, 26, 27, 30) durch magnetische Steuerungen von der Umgebung abgetrennt sind.

6. Optische Tastatur nach einem der Ansprüche 1 bis 5, dadurch gekennzeichnet, daß die Unterbrechungskoppler (14, 26, 27, 30) mit Sammlungskopplern (45) und/oder mit Teilungskopplern (44) verbunden sind.

7. Verfahren zur Herstellung einer optischen Tastatur nach Anspruch 1, welches darin besteht, daß ein einzelner Leiter auf jeden Unterbrechungskoppler plaziert wird und daß anschließend jeder dieser Leiter auf der Höhe des Kopplers geteilt wird, wodurch zwei Leiter (2, 3) entstehen, welche geeignet sind, den Unterbrechungskoppler mit einem der optischen Eingänge und einem der optischen Ausgänge zu verbinden.

8. Verfahren zu Herstellung einer optischen Tastatur nach Anspruch 7, dadurch gekennzeichnet, daß es daraus besteht:
   - Sammelführungen (34, 35) vorzugehen, um die Eingangsleiter (2) und die Ausgangsleiter (3) umzugruppieren im Hinblick auf ihren Anschluß an die jeweiligen Lichtquellen und Detektoren;
   - Halterungsführungen (8 und/oder 5) für die Leiter an den durch die Tasten betätigten Kopplungspunkten anzubringen;
   - die optischen Leiter um eine Sammelführung für Eingangs-(34) oder Ausgangsleiter (35) zu legen, dann um die Halterungsführung (8 und/oder 5) des entsprechenden Kopplungspunktes, um zu einer der ersten Sammelführung und dem belegten Kopplungspunkt entsprechenden zweiten Ausgangs- (35) oder Eingangs-Sammelführung (34) zurückzukehren;
   - diese Einzug-Schritte zu wiederholen, indem der Leiter in den optischen Block zurückgeführt wird, so daß alle Tasten-Kopplungspunkte belegt werden können;
   - die Eingangs- und Ausgangsleiter auf der Höhe der Ausgangs-(34) und Eingangs-Sammelführungen (35) durchzuschneiden.

9. Verfahren zur Herstellung einer optischen Tastatur nach Anspruch 7, dadurch gekennzeichnet, daß es daraus besteht:
   - die optischen Leiter auf den Kopplern (4) anzubringen;
   - Sammelführungen (34, 35) vorzusehen, um die Eingangsleiter (2) und die Ausgangsleiter (3) umzugruppieren im Hinblick auf ihren Anschluß an die jeweiligen Lichtquellen und Detektoren;
   - optische Leiter um eine Sammelführung zu Eingangs- (34) oder Ausgangsleiter (35) zu legen, dann den Koppler (4) auszurichten, um zu einer der ersten Sammelführung und dem ausgerichteten Kopplungspunkt entsprechenden zweiten Ausgangs- (35) oder Eingangs-Sammelführung (34) zurückzukehren;
   - diese Einzug-Schritte zu wiederholen, indem der Leiter in den optischen Block zurückgeführt wird, so daß alle Tasten-Kopplungspunkte plaziert werden können;
   - die Eingangs- und Ausgangsleiter auf der Höhe der Ausgangs-(34) und Eingangs-Sammelführungen (35) durchzuschneiden.

FIG.1

FIG.2

FIG.3

FIG.4

FIG.5

FIG.6

FIG.7

FIG.8

FIG.9

FIG.10

FIG.11

FIG.12

FIG.13

15

FIG.14